# EUROPEAN PATENT SPECIFICATION

(11) **EP 1 269 544 B1**
(45) Date of publication and mention of the grant of the patent: **15.12.2010**
(21) Application number: 01943531.2
(22) Date of filing: 20.06.2001
(51) Int. Cl.: H01L 27/148, H01L 21/339

(54) **METHOD OF MANUFACTURING A CHARGE-COUPLED IMAGE SENSOR**
VERFAHREN ZUR HERSTELLUNG EINER LADUNGSGEKOPPELTEN BILDAUFNAHMEVORRICHTUNG
PROCEDE DE FABRICATION D'UN CAPTEUR D'IMAGE A TRANSFERT DE CHARGE

(30) Priority: 27.06.2000 EP 00202247
(43) Date of publication of application: 02.01.2003
(73) Proprietor: DALSA INC., Waterloo Ontario N2V 2E9 (CA)
(72) Inventor: PEEK, Hermanus, L., NL-5656 AA Eindhoven (NL); VERBUGT, Daniel, W., E., NL-5656 AA Eindhoven (NL); BEENHAKKERS, Monique, J., NL-5656 AA Eindhoven (NL)
(74) Representative: Smeets, Eugenius Theodorus J. M.
(86) International application number: PCT/EP2001/007011
(87) International publication number: WO 2002/001602

(56) References cited:
- EP-A- 0 723 288
- WO-A-00/38233
- WO-A-98/11608
- US-A- 3 927 468
- US-A- 4 992 392
- US-A- 5 238 863
- US-A- 5 238 863
- US-A- 5 880 777
- US-A- 5 880 777
- PATENT ABSTRACTS OF JAPAN vol. 015, no. 135 (E-1052), 4 April 1991 (1991-04-04) & JP 03 016232 A (MATSUSHITA ELECTRON CORP), 24 January 1991 (1991-01-24)

## Description

The invention relates to a method of manufacturing a charge-coupled image sensor, wherein semiconductor regions are formed in a silicon slice so as to adjoin a surface thereof by implantation of ions of dopants and subsequent thermal treatments, wherein the surface of the silicon slice is provided with a gate dielectric comprising a layer of silicon oxide and a silicon nitride layer deposited thereon, and wherein a system of electrodes is formed on the gate dielectric.

Such a method is disclosed in, for example, WO 98/11608, wherein an n-type doped silicon slice is used as the starting material, in which a p-type doped surface region, referred to as p-well, adjoining a surface of the slice is formed at the location of the sensor to be formed. In this p-well, n-type channel-shaped semiconductor regions suitable for charge transport and extending parallel to each other are formed, and p-type channel-stop regions separating the channels are formed between said semiconductor regions. After the formation of these semiconductor regions, the surface of the slice is provided with a gate dielectric comprising a layer of a thermally formed silicon oxide and a silicon nitride layer deposited thereon. A system of polycrystalline silicon electrodes directed transversely to the channels is formed thereon.

In practice, to form the above-mentioned semiconductor regions, the surface of the slice is provided each time, i.e. in this case three times, with a thin layer of silicon oxide, also referred to as pad oxide. Subsequently, a photoresist mask is formed on the layer of pad oxide, after which the implantation of ions of a dopant is carried out, the photoresist mask is removed, a thermal treatment is carried out and, finally, the layer of pad oxide is etched away. When this layer of silicon oxide is etched away, also any impurities that may have entered this layer during the formation of the semiconductor regions are removed. After the removal of the pad oxide, the surface of the slice is rinsed and dried. In this manner, contamination of the silicon slice is counteracted.

In practice, the image sensors thus manufactured sometimes exhibit a comparatively large dark current and a comparatively high fixed pattern noise. In addition, errors in the form of white dots, commonly referred to as white spots, are observed in the images picked up by said image sensors.

It is an object of the invention, inter alia, to obviate said drawbacks. To achieve this, the method in accordance with the invention is characterized in that the semiconductor regions are not formed in the silicon slice until after the gate dielectric has been provided on the surface of the silicon slice, the ions of the dopants being implanted through the gate dielectric.

In the method in accordance with the invention, the above-mentioned pad oxide and the associated etch treatment wherein the pad oxide and the impurities present therein are removed, are dispensed with. Surprisingly, it has been found that this method enables image sensors to be manufactured which, in comparison with the sensors manufactured by means of the known method described above, exhibit a smaller dark current and a lower fixed pattern noise, and in which the occurrence of so-called white-spot image errors is precluded. It is assumed that, in the known method, after etching away pad oxide and carrying out the subsequent rinsing and drying operations, wherein the surface of the silicon slice is exposed, impurities remain on the surface of the slice, which diffuse in the slice or bond to the surface during subsequent thermal treatments. As such treatments are carried out several times, viz. three times in the prior-art method described herein, comparatively many impurities may be present below the gate dielectric, at and close to the surface. The occurrence of the above-mentioned large dark current, high fixed pattern noise and image errors in the form of white spots can be attributed thereto. In the method in accordance with the invention, the pad oxide process steps are omitted. In this method, like in the prior-art method, a photoresist mask is formed several times directly on the gate dielectric, an implantation is carried out, the photoresist mask is removed, the surface of the slice is cleaned by means of a rinsing and drying treatment, and a thermal treatment is carried out. After the formation of the gate dielectric, the surface of the slice is not exposed. Any impurities remain in the silicon nitride layer. It has been found that they do not adversely affect the proper operation of the image sensor.

US 3,927,468 that has been published on December 23, 1975 shows a fabrication method for a self aligned CCD element. In this document by forming a channel, including barrier regions formed therein, after formation of the gate electrodes, misalignments between gate electrodes and barrier regions in the channel region are avoided. In this way glitches, i.e. irregularities in the potential profile in the channel of a CCD element caused by said misalignment, are avoided.

US 5,880,777 that has been published on March 9, 1999 shows a fabrication method of an imaging system in which for a start on a silicon substrate a silicon dioxide layer is grown. Subsequently a silicon nitride layer is deposited on the silicon dioxide layer. Channel stop regions are defined by forming holes in the silicon nitride layer by etching silicon nitride exposed by photolithographic definition. Subsequently channel stop regions are then formed by an implantation followed by a thermal treatment.

Preferably, the silicon nitride layer is deposited on the silicon oxide layer by means of a LPCVD (Low Pressure Chemical Vapor Deposition) process. A high-density silicon nitride layer is thus obtained. Applying such a high-density layer in a small thickness is sufficient to make sure that said impurities do not reach the surface of the slice. For additional certainty, a silicon nitride layer can be deposited in a thickness of at least 20 nm.

These and other aspects of the invention will be apparent from and elucidated with reference to the embodiment(s) described hereinafter.

In the drawings:
Fig. 1 diagrammatically shows a plan view of a relevant part of a charge-coupled image sensor manufactured by means of the method in accordance with the invention, and
Fig. 2 through Fig. 11 are diagrammatic, cross-sectional views of several stages in the manufacture of the charge-coupled image sensor shown in plan view in fig. 1.

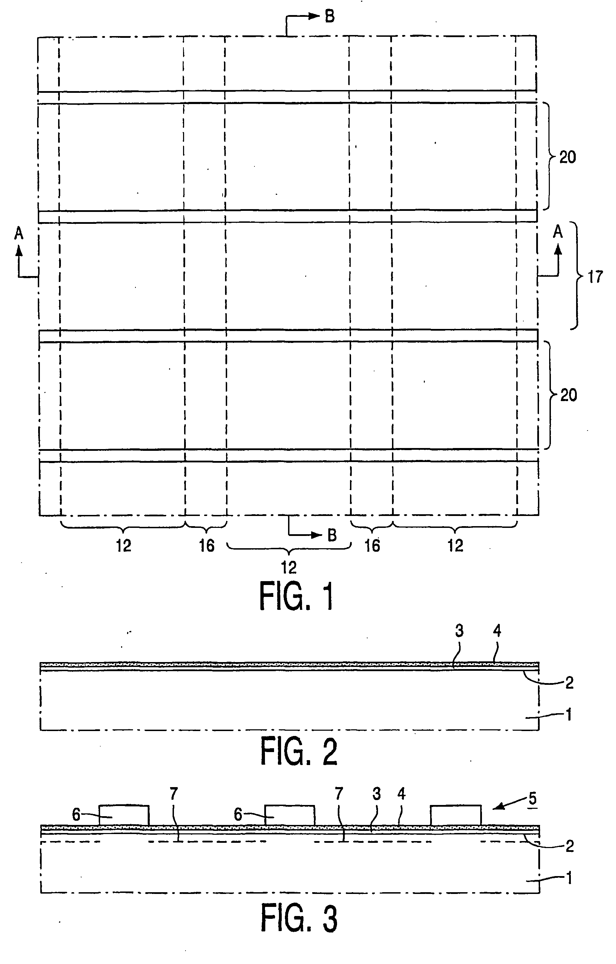

Fig. 1 is a diagrammatic plan view of a relevant part of a charge-coupled image sensor manufactured by means of the method in accordance with the invention, and Figs. 2 through 10 are diagrammatic, cross-sectional views of several stages in the manufacture of the image sensor shown in Fig. 1. The sensor shown in this example is an n-type buried channel sensor with vertical anti-blooming.

In the manufacture of this sensor, an n-type doped silicon slice 1 having a surface 2 is used as the starting material. Semiconductor regions 8, 12 and 16 adjoining the surface 2 are formed in the slice 1 in a customary manner by implantation of ions of dopants and subsequent thermal treatments. The surface 2 is provided with a gate dielectric 3, 4 comprising a layer of silicon oxide 3 and a silicon nitride layer 4 deposited thereon. A system of electrodes 17, 20 is formed on the gate dielectric 3, 4.

As shown in Fig. 2, first the gate dielectric 3, 4 is formed on the surface 2 of the slice 1. In a first step, an approximately 60 nm thick silicon oxide layer 3 is formed in a customary manner by thermal oxidation of the surface 2 of the slice 1. Next, an approximately 75 nm thick silicon nitride layer 4 is deposited thereon by means of a customary LPCVD (Low Pressure Chemical Vapor Deposition) process.

The following process steps, illustrated in Figs. 3 through 8, are shown with reference to the cross-sections taken on the line A-A in Fig. 1.

After the gate dielectric 3, 4 has been formed, the semiconductor regions 8, 12, and 16 are formed in the slice 1. First, p-type doped regions, commonly referred to as p-wells, adjoining the surface 2 are formed. In practice, generally more than one image sensor is formed on the slice, and, for each sensor, a p-well, as described hereinafter, being formed not only for the actual sensor, but p-wells also being formed for electronics to be integrated in the sensor, such as a read-out register and signal amplifiers. To form the p-well of the actual sensor, the surface 2, as shown in Fig. 3, is provided with a photoresist mask 5 comprising strips of photoresist 6 extending transversely to the plane of the drawing. Subsequently, boron ions, indicated by means of dashed lines 7, are implanted. After the removal of the photoresist mask 5, a thermal treatment is carried out leading to the formation of the p-well 8. The implanted ions diffuse in the slice so as to form a p-well whose thickness; at the location of channel regions 12 to be formed, is smaller than at the location of channel-stop regions 16 to be formed.

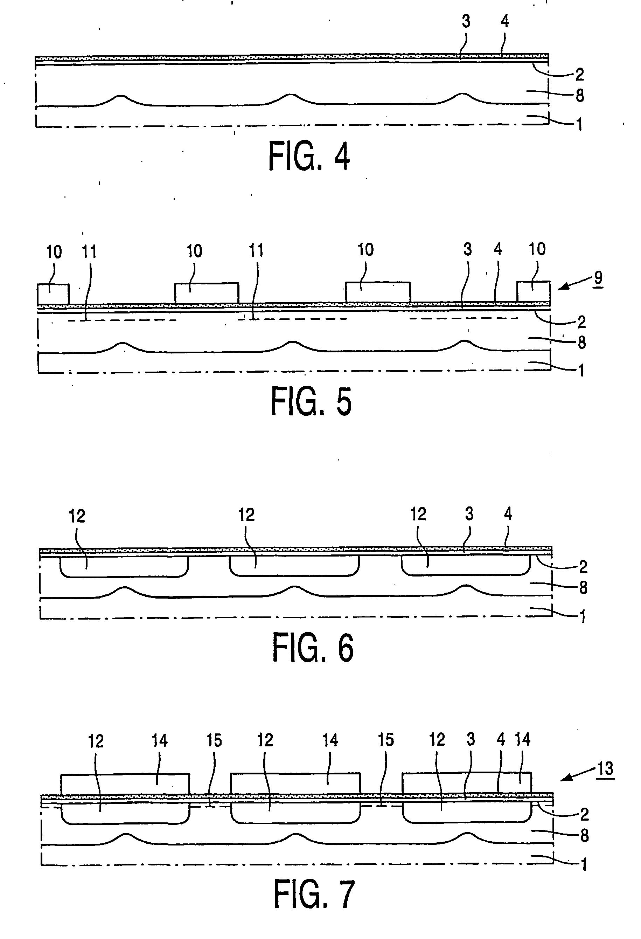

As shown in Fig. 5, after the formation of the p-well 8 on the gate dielectric 3, 4, a photoresist mask 9 is formed comprising strips of photoresist 10 extending transversely to the plane of the drawing. This photoresist mask 9 is used to define n-type channels to be formed in the p-well 8. After the formation of the photoresist mask 9, phosphor ions, indicated by means of dashed lines 11, are implanted in the slice 1. After the removal of the photoresist mask 9, the slice is subjected to a thermal treatment wherein the n-type channel zones 12, shown in Figs. 1 and 6, are formed. Centrally below these channels, the p-well 9 has a smaller thickness. In Fig. 1, the channel regions 12 are shown in a plan view indicated by means of dashed lines.

After the formation of the n-type channels 12, the gate dielectric 3, 4 is provided, as shown in Fig. 7, with a next photoresist mask 13 comprising strips of photoresist 14 extending transversely to the plane of the drawing. Said photoresist mask 14 serves to define, in the p-well 8, the channel-stop regions separating the n-type channels 12 from each other. After the formation of the photoresist mask 13, boron ions, indicated by means of dashed lines 15, are implanted in the slice 1. After the removal of the photoresist mask 13, the slice is subjected to a thermal treatment wherein the p-type channel-stop regions 16, as shown in Figs. 1 and 7, are formed. The channel-stop regions 16 indicated by means of dashed lines are also shown in a plan view in Fig. 1.

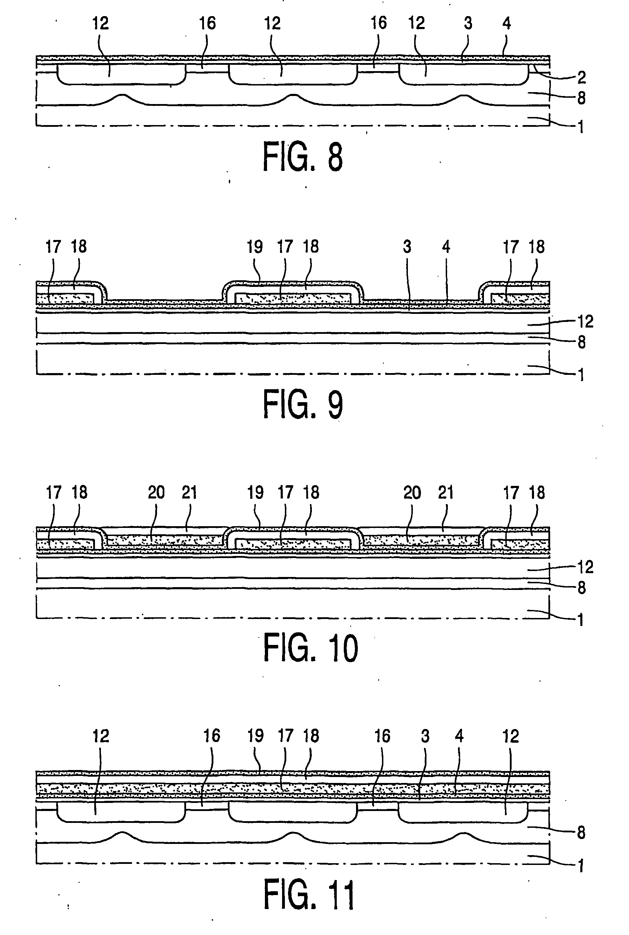

The following process steps, illustrated in Figs. 9 and 10, are shown with reference to the cross-sectional views taken on the line B-B in Fig. 1.

After the formation of the semiconductor regions 8, 12 and 16, an approximately 500 nm thick n-type conductive layer of polycrystalline silicon 14 is deposited in a customary manner on the gate dielectric 3, 4, a first system of electrodes 17 being etched in said polycrystalline silicon layer. These electrodes are provided with an insulating layer of thermally formed silicon oxide 18. By virtue of the presence of the silicon nitride layer 4, a mask is not necessary to carry out the oxidation process. The whole is subsequently covered with a silicon nitride layer 19. A plan view of the electrodes 17 is shown in Fig. 1.

After the formation of the first system of electrodes 17, a next layer of polycrystalline silicon is deposited wherein a second system of electrodes 20 is formed which extend between the electrodes 17. Also these electrodes are provided with a thermally formed layer of silicon oxide 21. By virtue of the presence of the silicon nitride layer 19, also this oxidation step does not require a mask. A plan view of the electrodes 20 is shown in Fig. 1. Fig. 10 shows the sensor thus manufactured in a cross-sectional view taken on the line A-A in Fig. 1.

If, during operation, an image is projected on such an image sensor, then the electric voltages applied to the electrodes 17, 20 are such that during a certain integration time charge packets are collected in the channels 12 below adjacent groups of electrodes 17, 20 (for example groups of four electrodes). The amount of charge in these pixels depends upon the amount of light incident on the pixels. After said integration time, electric pulses are applied to the electrodes 17, 20, causing the charge packets to be transported through the channels 12 to a read-out register. The image information thus obtained can be read from this read-out register. The depth and the doping concentration of the semiconductor regions 8 and 12 are chosen to be such that, in the thinner parts of the p-well 8 below the channels 12, such a potential barrier is formed that charge generated in the channels 12 by exposure to light cannot exceed a maximum. Any excess charge can flow across said potential barrier to the part of the slice 1 situated below the p-well 8. It is thus precluded that excess charge spreads over a plurality of adjacent pixels.

In the method in accordance with the invention, the semiconductor regions 8, 12 and 16 are not formed until after the gate dielectric 3, 4 has been formed. Any impurities landing on the surface during the implantations and the subsequent thermal treatments and cleaning steps remain in the silicon nitride layer and do not reach the slice situated below the gate dielectric 3, 4. In the gate dielectric, these impurities could give rise to large dark currents, a high fixed pattern noise and image errors in the form of white spots. The method described herein enables a charge-coupled image sensor to be manufactured having a very small dark current, i.e. below 200 pA per cm². In addition, an image sensor manufactured in this manner is substantially free of fixed pattern noise and image errors in the form of white spots.

The layer of silicon nitride 4 is deposited on the silicon oxide layer by means of a LPCVD (Low Pressure Chemical Vapor Deposition) process. In this manner, a high-density silicon nitride layer 4 is obtained. Applying such a high-density layer in a small thickness is sufficient to make sure that said impurities do not reach the surface 2 of the slice 1. For additional certainty, a silicon nitride layer can be deposited in a thickness of at least 20 nm.

By way of example, a description has been given of the manufacture of an n-type buried channel sensor with vertical anti-blooming. It will be obvious, however, that the method can also advantageously be employed for the manufacture of other charge-coupled image sensors, such as an interline image sensor.

## Claims

1. A method of manufacturing a charge-coupled image sensor, wherein semiconductor regions (8, 12, 16) are formed in a silicon slice (1) so as to adjoin a surface (2) thereof by implantation of ions of dopants and subsequent thermal treatments, wherein for the semiconductor regions (8, 12, 16) a well region (8), channel regions (12) and channel-stop regions (16) are chosen, wherein the surface of the silicon slice (1) is provided with a gate dielectric (3,4) comprising a layer of silicon oxide (3) and a silicon nitride layer (4) deposited thereon, and wherein a system of electrodes (17,20) is formed on the gate dielectric (3,4), **characterized in that** the semiconductor regions (8, 12, 16) are not formed in the silicon slice (1) until after the gate dielectric (3,4) has been provided on the surface (2) of the silicon slice (1), the ions of the dopants being implanted through the gate dielectric (3,4), the surface of the silicon slice (1) being protected during the implantations and subsequent thermal treatments and cleaning steps by the presence of the silicon nitride layer (4) in which impurities remain so that impurities can not reach the silicon slice (1) situated below the gate dielectric (3,4).

2. A method as claimed in claim 1, **characterized in that** the silicon nitride layer (4) is deposited on the silicon oxide layer (3) by means of a LPCVD (Low Pressure Chemical Vapor Deposition) process.

3. A method as claimed in claim 2, **characterized in that** the silicon nitride layer (4) is deposited in a thickness of at least 50 nm.

## Patentansprüche

1. Verfahren zur Herstellung eines ladungsgekoppelten Bildsensors, wobei Halbleiterbereiche (8, 12, 16) durch eine Implantation von Ionen von Dotierstoffen und anschließende Wärmebehandlungen so in einer Siliziumscheibe (1) gebildet werden, dass sie an eine Fläche (2) davon angrenzen, wobei für die Halbleiterbereiche (8, 12, 16) ein Wannenbereich (8), Kanalbereiche (12) und Kanalbegrenzungsbereiche (16) gewählt werden, wobei die Oberfläche der Siliziumscheibe (1) mit einem Gatedielektrikum (3, 4) versehen wird, das eine Schicht aus Siliziumoxid (3) und eine darauf abgelagerte Siliziumnitridschicht (4) umfasst, und wobei auf dem Gatedielektrikum (3,4) ein System von Elektroden (17, 20) gebildet wird, **dadurch gekennzeichnet, dass** die Halbleiterbereiche (8, 12, 16) erst nach dem Bereitstellen des Gatedielektrikums (3, 4) an der Oberfläche (2) der Siliziumscheibe (1) in der Siliziumscheibe (1) gebildet werden, die Ionen der Dotierstoffe durch das Gatedielektrikum (3, 4) implantiert werden, und die Oberfläche der Siliziumscheibe (1) während der Implantationen und der anschließenden Wärmebehandlungen und Reinigungsschritte durch das Vorhandensein der Siliziumnitridschicht (4), in der Verunreinigungen zurückbleiben, so dass Verunreinigungen die unter dem Gatedielektrikum (3, 4) gelegene Siliziumscheibe (1) nicht erreichen können, geschützt wird.

2. Verfahren nach Anspruch 1, **dadurch gekennzeichnet, dass** die Siliziumnitridschicht (4) durch einen LPCVD-Prozess (Low Pressure Chemical Vapor Deposition, Niederdruck-Gasphasenbeschichtung) auf der Siliziumoxidschicht (3) abgelagert wird.

3. Verfahren nach Anspruch 2, **dadurch gekennzeichnet, dass** die Siliziumnitridschicht (4) mit einer Dicke von zumindest 50 nm abgelagert wird.

## Revendications

1. Procédé de fabrication d'un capteur d'image à couplage de charge, dans lequel des régions de semi-conducteurs (8, 12, 16) sont formées dans une tranche de silicium (1) pour être contiguës à une surface (2) de celle-ci par implantation d'ions de dopants puis par traitements thermiques, dans lequel pour les régions de semi-conducteurs (8, 12, 16) une région de puits (8), des régions de canal (12) et des régions d'arrêt de canal (16) sont choisies, dans lequel la surface de la tranche de silicium (1) est pourvue d'un diélectrique de grille (3, 4) comprenant une couche d'oxyde de silicium (3) et une couche de nitrure de silicium (4) déposées sur celui-ci, et dans lequel un système d'électrodes (17, 20) est formé sur le diélectrique de grille (3, 4), **caractérisé en ce que** les régions de semi-conducteurs (8, 12, 16) ne sont formées dans la tranche de silicium (1) qu'après que le diélectrique de grille (3, 4) est fourni sur la surface (2) de la tranche de silicium (1), les ions de dopants étant implantés à travers le diélectrique de grille (3, 4), la surface de la tranche de silicium (1) étant protégée pendant les implantations et les traitements thermiques ultérieurs et les étapes de nettoyage par la présence de la couche de nitrure de silicium (4) dans laquelle il reste des impuretés de sorte que les impuretés ne puissent pas atteindre la tranche de silicium (1) située au-dessous du diélectrique de grille (3, 4).

2. Procédé selon la revendication 1, **caractérisé en ce que** la couche de nitrure de silicium (4) est déposée sur la couche d'oxyde de silicium (3) au moyen d'un processus LPCVD (Low Pressure Chemical Vapor Deposition, dépôt de vapeurs chimiques à basse pression).

3. Procédé selon la revendication 2, **caractérisé en ce que** la couche de nitrure de silicium (4) est déposée dans une épaisseur d'au moins 50 nm.
